# FASCICULE DE BREVET EUROPEEN

(11) **EP 0 585 153 B1**
(45) Date de publication et mention de la délivrance du brevet: **15.04.1998**
(21) Numéro de dépôt: 93401923.3
(22) Date de dépôt: 23.07.1993
(51) Int. Cl.: G11C 7/00

(54) **Mémoire en circuit intégré avec précharge préalable en sortie**
Integrierte Speicherschaltung mit Ausgangsvorladung
Integrated memory circuit with output preliminary precharge

(30) Priorité: 24.07.1992 FR 9209197
(43) Date de publication de la demande: 02.03.1994
(73) Titulaire: SGS-THOMSON MICROELECTRONICS S.A., 94250 Gentilly (FR)
(72) Inventeur: Gaultier, Jean-Marie, F-75116 Paris (FR)
(74) Mandataire: Ballot, Paul Denis Jacques

(56) Documents cités:
- EP-A- 0 319 223
- EP-A- 0 471 289
- IEEE JOURNAL OF SOLID-STATE CIRCUITS. vol. 23, no. 5 , Octobre 1988 , NEW YORK US pages 1060 - 1066 KOHNO ET AL 'A 14-NS 1-MBIT CMOS SRAM WITH VARIABLE BIT ORGANISATION.'

## Description

L'invention concerne les mémoires réalisées en circuit intégré. Elle concerne tout particulièrement, bien que non exclusivement, les mémoires non volatiles programmables et effaçables électriquement (EEPROM, flash EPROM).

Un des facteurs importants dans l'utilisation des mémoires en circuit intégré est la rapidité de l'accès à l'information contenue dans les cellules. Or de nombreux facteurs tendent à limiter cette rapidité, surtout dans les mémoires ayant une grande capacité de stockage (1 mégabit et plus).

Il est connu d'utiliser une précharge de ligne de bit avant la phase de lecture proprement dite : la ligne de bit à laquelle est connectée une colonne de cellules de mémoire est préchargée à une tension intermédiaire entre un niveau logique haut et un niveau logique bas, avant la phase de lecture proprement dite.

L'amplificateur de lecture qui est connecté entre cette ligne de bit et une ligne de référence, basculera dans un sens ou dans l'autre au moment de la lecture, selon l'état de la cellule à lire.

Un but de l'invention est d'améliorer la rapidité de transmission de l'information à la sortie des mémoires.

Selon l'invention on propose de précharger à une valeur intermédiaire entre un niveau logique haut et un niveau logique bas le (ou les) plot(s) de sortie de la puce de circuit intégré, sur lequel apparaissent les informations logiques contenues dans la mémoire.

On a constaté en effet qu'un facteur de ralentissement de l'accès à l'information pouvait être dû à ce qui se passe à l'extérieur de la mémoire (par exemple une charge capacitive élevée connectée à l'extérieur de la mémoire), mais que ce ralentissement pouvait être partiellement compensé par des mesures prises à l'intérieur de la puce de mémoire.

Le document EP-A-0 471 289 sur lequel se fonde le préambule de la revendication 1, dévoile un dispositif de préchargement d'un plot de sortie piloté par deux transistors où l'on rend conducteur un seul des transistor suivant l'état de la sortie avant la précharge. Le document EP-A-0 319 223 dévoile un dispositif de préchargement d'un plot de sortie piloté par deux transistors où l'on rend conducteur un des transistors en fonction de la tension présente sur le plot de sortie pendant la précharge pour obtenir une tension prédéfinie qui correspond à la conduction simultanée des deux transistors.

On propose donc selon l'invention une mémoire en puce de circuit intégré, comportant un réseau de cellules de mémoire raccordées à au moins une ligne de bit, la ligne de bit étant reliée par l'intermédiaire d'au moins un amplificateur de sortie à un plot de sortie de la puce de mémoire, comportant des moyens pour précharger la sortie de l'amplificateur jusqu'à une valeur de tension prédéterminée pendant une phase de précharge avant d'appliquer sur le plot par l'amplificateur de sortie, pendant une phase de lecture suivant la phase de précharge, un niveau logique correspondant à une information lue dans une cellule de la mémoire, la valeur prédéterminée étant intermédiaire entre une valeur de tension correspondant à un niveau logique haut et une valeur de tension correspondant à un niveau logique bas, l'amplificateur de sortie comportant un transistor de charge en série avec un transistor de décharge, le point commun des transistors étant relié au plot, avec des moyens pour commander la conduction de ces transistors, ces moyens comportant des moyens pour rendre le transistor de charge conducteur et bloquer le transistor de décharge lorsque l'information transmise par la ligne de bit correspond à un niveau logique haut, et des moyens pour rendre le transistor de décharge conducteur et bloquer le transistor de charge lorsque l'information transmise par la ligne de bit correspond à un niveau logique bas, et comportant, relié au plot de sortie, un circuit de mémorisation apte à garder en mémoire pendant la phase de précharge le niveau logique présent sur le plot pendant la phase de lecture précédente, ce circuit ayant sa sortie connectée pendant la phase de précharge aux moyens pour commander la conduction des transistors de charge et de décharge, de manière à interdire la conduction du transistor de charge ou du transistor de décharge pendant la précharge selon que le niveau logique mémorisé est haut ou bas, caractérisée en ce que la mémoire comporte un inverseur à seuil pour autoriser la mise en conduction de celui des transistors de charge et de décharge dont la conduction n'est pas interdite, tant que le potentiel du plot n'a pas atteint la valeur intermédiaire de précharge désirée, et pour arrêter cette conduction dès que le potentiel du plot atteint cette valeur.

De préférence, les moyens de précharge comportent des moyens, actifs pendant une phase de précharge, pour décharger vers une borne d'alimentation à potentiel bas le bloc de sortie s'il est resté à un potentiel haut lors de la lecture précédente, et pour charger le plot à partir d'une borne d'alimentation à potentiel haut si le plot est resté à un potentiel bas après une lecture précédente.

On prévoit de préférence au moins un détecteur à seuil ayant une entrée reliée au plot pour surveiller le potentiel du plot et pour limiter la charge ou la décharge du plot à ladite valeur de potentiel intermédiaire pendant la phase de précharge.

Selon une réalisation avantageuse, l'amplificateur de sortie comporte un transistor de charge et un transistor de décharge reliés tous deux au plot de sortie, une première porte logique pour commander le transistor de charge et une deuxième porte logique pour commander le transistor de décharge. La première porte permet de faire conduire le transistor de charge d'une part pendant la phase de lecture pour un premier état logique d'une donnée à lire, et d'autre part pendant la phase de précharge tant que le plot n'est pas chargé jusqu'à la valeur intermédiaire. La deuxième porte logique permet réciproquement de faire conduire le transistor de décharge d'une part pendant la phase de lecture pour un deuxième état logique de signal à lire, et d'autre part pendant la phase de précharge tant que le plot n'est pas déchargé jusqu'à la tension intermédiaire.

Des détecteurs à seuil séparés peuvent être prévus pour commander la première porte et la deuxième porte respectivement.

Dans une réalisation particulière, on prévoit un circuit de mise en mémoire de l'état logique du plot lors d'une lecture précédente, et une connexion entre la sortie de ce circuit de mise en mémoire et les portes logiques, cette connexion étant activée pendant la phase de précharge, pour inhiber la conduction de l'un ou l'autre des transistors selon l'état logique du plot lors de la lecture précédente.

Enfin, de préférence, on prévoit des circuits de maintien, entre la sortie de l'amplificateur différentiel et les entrées des portes logiques, pour maintenir sur les entrées de ces portes l'état du signal lu précédemment, entre la fin d'une phase de lecture et le début d'une phase de précharge ultérieure.

Les caractéristiques et avantages de l'invention apparaîtront à la lecture de la description détaillée qui suit et qui est faite en référence aux dessins annexés dans lesquels :
- la figure 1 représente un mode de réalisation préféré de l'invention;
- la figure 2 représente un diagramme temporel représentant les phases de fonctionnement du circuit de la figure 1.

La mémoire comprend un réseau de cellules de mémoire. Les cellules de mémoire MC d'une même colonne sont connectées à un conducteur commun appelé ligne de bit BL, ce conducteur servant à transmettre une information sur l'état d'une cellule de la colonne, cette cellule étant désignée par une ligne de mot WL.

L'information est lue à l'aide d'un amplificateur différentiel AD qui, pendant une phase de lecture, est relié à la ligne de bit BL, préalablement préchargée par des moyens non représentés, et sur une autre entrée le potentiel présent sur une ligne de référence LR.

L'information sur l'état de la cellule est constituée par un signal DATA en sortie de l'amplificateur différentiel AD. Ce signal DATA est un signal logique haut ou bas selon l'information lue dans la cellule désignée au moment de la lecture.

Ce signal logique DATA doit être transmis à un plot extérieur de la mémoire, désigné par la référence IOPAD; un amplificateur de sortie ou amplificateur tampon sert à transmettre la valeur logique du signal DATA sur une sortie de la mémoire qui peut être le plot IOPAD, avec une impédance de sortie assez faible pour alimenter des circuits connectés à l'extérieur de la puce de mémoire.

Selon l'invention, l'amplificateur de sortie fonctionne selon deux phases : précharge d'abord, puis transmission du niveau logique du signal DATA.

L'amplificateur tampon comporte deux transistors de sortie qui servent à fournir le niveau logique désiré sur le plot IOPAD. Ce sont respectivement un transistor de charge T1 et un transistor de décharge T2. En technologie CMOS on utilisera un transistor de charge à canal P, ayant sa source reliée à une borne d'alimentation positive A, et un transistor de décharge à canal N, ayant sa source reliée à une borne d'alimentation basse B. Les drains des transistors sont reliés au plot IOPAD. Le transistor T1 doit être conducteur et T2 bloqué lorsque le signal DATA correspond à la mise au niveau logique haut du plot IOPAD; inversement, le transistor T1 doit être bloqué et le transistor T2 conducteur lorsque le signal DATA correspond à la mise au niveau logique bas du plot.

On comprend que si une première lecture d'information conduit à mettre le plot IOPAD à un potentiel haut, la deuxième lecture fournira une information rapide si elle doit également conduire à un niveau haut mais plus lente si elle doit conduire à un niveau bas car dans ce deuxième cas il faudra prendre le temps de décharger le plot et les lignes extérieures connectées à ce plot. Inversement, si la lecture précédente place le plot à un niveau bas, l'obtention d'une information sera retardée si la nouvelle information correspond à un niveau logique haut.

Pour équilibrer la rapidité de fourniture de l'information dans les deux cas possibles (fourniture successive de deux niveaux identiques ou fourniture de deux niveaux différents), on précharge le plot de sortie à une valeur intermédiaire entre les deux niveaux logiques, pendant une phase de précharge précédant immédiatement la lecture proprement dite. Les niveaux logiques considérés ici sont les niveaux standards admis dans la technologie utilisée. Par exemple, en technologie CMOS ces niveaux peuvent être de 0,8 volts pour le niveau bas et de 2 volts pour le niveau haut. La valeur intermédiaire pourra être d'environ 1,4 volts.

Le séquencement des opérations comportera donc, à partir d'un instant t0 défini par la détection d'un changement d'adresse (ADR) d'information à lire, d'abord une phase de précharge PRECH (t0 à t1, durée de l'ordre de 30 nanosecondes par exemple), puis une phase de lecture LECT (t1 à t2, de l'ordre de 10 nanosecondes), puis une phase d'attente d'un nouveau changement d'adresse d'information à lire.

On notera que cette phase supplémentaire de précharge ne perd pas de temps puisqu'elle peut être effectuée en même temps que la phase de précharge de la ligne de bit BL, avant l'élaboration du signal DATA.

Une première porte logique PL1 commande la grille du transistor T1, et une deuxième porte logique PL2 commande la grille du transistor T2.

Dans l'exemple représenté, la porte logique PL1 est une porte NAND à deux entrées, et la porte logique PL2 est une porte NOR à deux entrées.

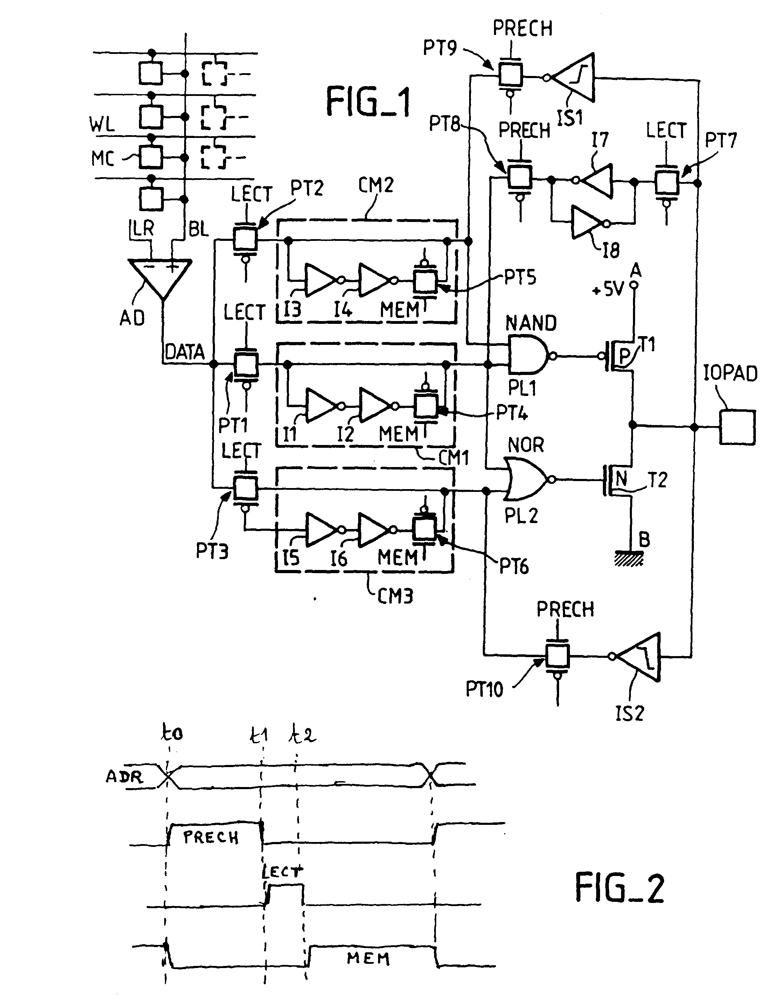

La première entrée de la porte NAND PL1 reçoit, au moment de la phase de lecture, le signal DATA représentant l'information à transmettre sur le plot de sortie. La première entrée de la porte NOR reçoit le même signal. La sortie de l'amplificateur AD est reliée à ces premières entrées par l'intermédiaire d'une porte de transfert PT1 ouverte seulement pendant la phase de lecture proprement dite, après la phase de précharge. Le signal LECT qui commande certaines portes de transfert de la figure définit cette phase de lecture (voir figure 2). Les portes de transfert sont constituées par un transistor MOS à canal N commandé par un signal logique, en parallèle avec un transistor MOS à canal P commandé par un signal logique complémentaire.

La deuxième entrée de la porte NAND PL1 reçoit également le signal DATA à travers une autre porte de transfert PT2, passante pendant la phase de lecture LECT.

De la même façon, la première entrée de la porte NOR PL2 reçoit le signal DATA à travers la porte PT1 et la deuxième entrée reçoit le signal DATA à travers une porte de transfert PT3 rendue passante par le signal LECT.

Pour des raisons qui tiennent à la nécessité de libérer très rapidement l'amplificateur différentiel AD pour une nouvelle lecture avant même que l'information ne soit complètement stabilisée sur le plot IOPAD, on prévoit des circuits de maintien auxiliaires qui mémorisent et maintiennent la valeur du signal DATA sur les entrées des portes logiques PL1 et PL2 même après disparition du signal DATA. Il y a un circuit de maintien après chaque porte de transfert PT1, PT2, PT3. Chaque circuit de maintien, respectivement CM1, CM2, CM3, comporte une boucle asservie comprenant deux inverseurs en cascade, en série avec une porte de transfert. L'entrée du deuxième inverseur est connectée à la sortie du premier, la sortie du deuxième inverseur est reliée à l'entrée de la porte de transfert, et la sortie de cette dernière est rebouclée sur l'entrée du premier inverseur. La porte de transfert du circuit de maintien est commandée par un signal MEM qui assure la sauvegarde de l'information (DATA) dès que le signal DATA correspondant à une nouvelle lecture a pris sa nouvelle valeur. Le signal MEM apparaît dès la fin de la phase de lecture (LECT) et est maintenu jusqu'à la phase de précharge suivante, c'est-à-dire pendant tout le temps d'attente avant la détection d'un changement d'adresse d'information à lire. Le premier circuit de maintien CM1, correspondant à un double inverseur I1, I2 et une porte de transfert PT4, est connecté à la sortie de la porte PT1, c'est-à-dire que l'entrée de l'inverseur I1 et la sortie de la porte PT4 sont reliées à cette sortie de la porte PT1.

De la même façon, le deuxième circuit de maintien CM2 (inverseurs I3, I4, porte de transfert PT5 commandée par le signal MEM) est relié à la sortie de la porte de transfert PT2. Le troisième circuit de maintien CM3 (inverseurs I5, I6, porte de transfert PT6 commandée par le signal MEM) est relié à la sortie de la porte de transfert PT3.

Lorsque le signal LECT est émis pour appliquer le signal DATA aux portes PL1 et PL2, le signal MEM est à l'état bas (portes PT4, PT5, PT6 bloquées).

Le signal de lecture LECT rend conductrices les portes PT1, PT2, PT3; le signal DATA apparaît sur les entrées des portes PL1 et PL2 puis se stabilise; le signal LECT peut alors être remis à l'état bas et le signal MEM appliqué est appliqué aux portes PT4, PT5, PT6 pour les rendre passantes et activer les circuits de maintien pour mémoriser le signal DATA. La valeur logique du signal DATA reste alors appliquée aux entrées des portes logiques PL1 et PL2 même si la sortie de l'amplificateur AD cesse de fournir le signal DATA.

Si le signal DATA est à un niveau logique haut (1), la sortie de la porte NAND passe à zéro puisque ses deux entrées sont à 1. Le transistor de charge T1 est alors rendu conducteur, chargeant le plot IOPAD au niveau logique haut à partir de la borne d'alimentation haute A. Le transistor T2 reste bloqué, la sortie de la porte NOR étant à 0 du fait que ses deux entrées sont à 1.

Si au contraire le signal DATA est à un niveau logique bas (0), la sortie de la porte NOR passe à 1 et rend conducteur le transistor de décharge T2 pour faire passer au niveau 0 le plot de sortie. La porte NAND fournit un niveau 1 qui bloque le transistor T1.

Pour la précharge, les éléments spécifiques supplémentaires suivants sont de préférence prévus : un circuit d'inhibition de l'une des portes PL1 et PL2 en fonction de l'état logique précédent du plot IOPAD, et un détecteur à seuil pour limiter la précharge du plot IOPAD à une valeur déterminée.

Sur la réalisation préférée, on a prévu un circuit de mémorisation de la valeur logique précédente du plot IOPAD. Ce circuit comporte par exemple un inverseur I7 rebouclé par un autre inverseur I8 plus résistif que le premier. L'entrée de ce circuit de mémorisation (entrée de l'inverseur I7) est reliée au plot par l'intermédiaire d'une porte de transfert PT7 rendue passante pendant la phase de lecture LECT; le circuit de mémorisation mémorise donc l'état du plot pendant la phase de lecture. La sortie du circuit de mémorisation (sortie de l'inverseur I7) est reliée à la première entrée de la porte NAND PL1 et à la première entrée de la porte NOR PL2, par l'intermédiaire d'une porte de transfert PT8 rendue passante pendant la phase de précharge PRECH. L'état logique présent sur le plot, inversé par l'inverseur I7 et mémorisé par cet inverseur, est donc transmis à l'entrée des portes NAND et NOR pendant toute la phase de précharge.

La sortie du circuit de mémorisation sert simplement à inhiber le fonctionnement de l'une ou l'autre des portes PL1 et PL2 pour interdire la conduction du transistor de charge ou du transistor de décharge selon l'état logique du plot à la lecture précédente : si l'état logique mémorisé est 1, un état 0 est transmis à l'entrée de la porte NAND pendant la phase de précharge suivante, ce qui interdit la conduction du transistor T1 quel que soit l'état de l'autre entrée; la porte NOR n'est pas affectée et peut faire conduire le transistor T2 selon l'état de l'autre entrée de cette porte. Inversement, si l'état du plot à la lecture précédente est 0, un état 1 est transmis par le circuit de mémorisation lors de la phase de précharge suivante pour venir interdire la conduction du transistor T2; la conduction du transistor T1 ne sera pas inhibée et dépendra de l'état de l'autre entrée de la porte NAND.

La deuxième entrée de la porte NAND PL1 reçoit la sortie d'une porte de transfert PT9 qui elle-même reçoit la sortie d'un inverseur à seuil IS1, l'entrée de ce dernier étant relié au plot IOPAD. On rappelle que la deuxième entrée de la porte NAND reçoit par ailleurs le signal DATA par la sortie du circuit de maintien CM2. Mais pendant la phase de précharge PRECH, le signal LECT et le signal MEM sont à zéro, bloquant les portes PT2 et PT5, de sorte que le signal DATA n'est plus transmis activement sur les entrées des portes NAND et NOR.

De la même manière, la deuxième entrée de la porte NOR PL2, qui ne reçoit plus le signal DATA de la lecture précédente pendant la phase de précharge PRECH, reçoit, par l'intermédiaire d'une porte de transfert PT10 activée par le signal PRECH, la sortie d'un inverseur à seuil IS2.

Les inverseurs à seuil servent à autoriser la mise en conduction de celui des transistors T1 ou T2 dont la conduction n'est pas interdite par le circuit d'inhibition pendant la précharge. Cette conduction est autorisée tant que le potentiel du plot n'a pas atteint la valeur intermédiaire de précharge désirée; elle est arrêtée ensuite.

Le seuil des inverseurs IS1 et IS2 est réglé à une valeur qui est directement liée à la valeur du potentiel de précharge qu'on veut appliquer sur le plot IOPAD pendant la phase de précharge.

En effet, le circuit fonctionne de la manière suivante : si le signal DATA de la lecture précédente est à 1, le plot est chargé à environ 5 volts à la fin de l'étape de lecture. Pendant la phase de précharge qui prépare la lecture suivante, la porte NAND est inhibée par la sortie de la porte PT8. La porte NOR reçoit un état logique 0 sur sa première entrée par la porte PT8 et un état logique 0 par l'inverseur à seuil puisque le plot est à 1. La porte NOR fournit à sa sortie un niveau haut; le transistor de décharge T2 devient conducteur et décharge le potentiel haut du plot IOPAD. Le potentiel de ce plot descend. Mais dès qu'il atteint la valeur de précharge désirée, définie par le seuil de l'inverseur IS2, l'inverseur IS2 bascule, fait basculer la porte NOR, et bloque le transistor T2, de sorte que la décharge du plot cesse. Le plot reste chargé à la valeur de précharge désirée intermédiaire entre un niveau logique haut et un niveau logique bas. La situation reste alors ainsi jusqu'à la fin de la phase de précharge PRECH et jusqu'à l'apparition du signal LECT qui définit la nouvelle phase de lecture.

Inversement, si le signal DATA de la lecture précédente était à 0, le plot est initalement déchargé à 0 volt à la fin de l'étape de lecture. Pendant la phase de précharge qui prépare la lecture suivante, c'est cette fois la porte NOR qui est inhibée par la sortie de la porte PT8. La porte NAND reçoit un état logique 1 sur sa première entrée par la porte PT8 et un état logique 1 par l'inverseur à seuil IS1 puisque le plot est à 0. La porte NAND fournit donc à sa sortie un niveau bas; le transistor de charge T1 devient conducteur et charge le plot IOPAD. Le potentiel de ce plot monte; dès qu'il atteint la valeur de précharge désirée, définie par le seuil de l'inverseur IS1, l'inverseur IS1 bascule, fait basculer la porte NAND, et bloque le transistor T1, de sorte que la charge du plot cesse. Le plot reste chargé à la valeur de précharge désirée intermédiaire entre un niveau logique haut et un niveau logique bas.

Etant donné qu'il est difficile de faire un inverseur à seuil fonctionnant sans hystérésis, c'est-à-dire basculant pour la même valeur de tension d'entrée aussi bien dans le sens des tensions croissantes que dans le sens des tensions décroissantes, on préfère utiliser deux inverseurs séparés IS1 et IS2, mais on comprendra que si on accepte une hystérésis les deux inverseurs pourraient être remplacés par un inverseur unique puisqu'ils sont connectés en parallèle.

Le niveau du potentiel intermédiaire auquel on précharge le plot est de préférence compris entre 1 et 2 volts, pour une alimentation en tension de 5 volts, et une valeur appropriée est 1,4 volts environ. Bien que l'alimentation soit de 5 volts, le niveau logique bas est considéré comme étant une valeur inférieure à 0,8 volts environ et le niveau logique haut est considéré comme atteint aux alentours de 2,2 volts. Ceci explique les valeurs indiquées comme gammes de valeurs intermédiaires préférées pour la précharge de la sortie de l'amplificateur.

## Revendications

1. Mémoire en puce de circuit intégré, comportant un réseau de cellules de mémoire raccordées à au moins une ligne de bit (BL), la ligne de bit étant reliée par l'intermédiaire d'au moins un amplificateur de sortie (T1, T2) à un plot de sortie de la puce de mémoire (IOPAD), comportant des moyens (IS1, IS2, PT9, PT10) pour précharger la sortie de l'amplificateur jusqu'à une valeur de tension prédéterminée pendant une phase de précharge avant d'appliquer sur le plot par l'amplificateur de sortie, pendant une phase de lecture suivant la phase de précharge, un niveau logique correspondant à une information lue dans une cellule de la mémoire, la valeur prédéterminée étant intermédiaire entre une valeur de tension correspondant à un niveau logique haut et une valeur de tension correspondant à un niveau logique bas, l'amplificateur de sortie comportant un transistor de charge (T1) en série avec un transistor de décharge (T2), le point commun des transistors étant relié au plot, avec des moyens (PL1, PL2) pour commander la conduction de ces transistors, ces moyens (PL1,PL2) comportant des moyens pour rendre le transistor de charge (T1) conducteur et bloquer le transistor de décharge (T2) lorsque l'information transmise par la ligne de bit correspond à un niveau logique haut, et des moyens pour rendre le transistor de décharge (T2) conducteur et bloquer le transistor de charge (T1) lorsque l'information transmise par la ligne de bit correspond à un niveau logique bas, et comportant, relié au plot de sortie, un circuit de mémorisation (I7, I8) apte à garder en mémoire pendant la phase de précharge le niveau logique présent sur le plot pendant la phase de lecture précédente, ce circuit (I7,I8) ayant sa sortie connectée pendant la phase de précharge aux moyens pour commander la conduction des transistors de charge et de décharge, de manière à interdire la conduction du transistor de charge ou du transistor de décharge pendant la précharge selon que le niveau logique mémorisé est haut ou bas, caractérisée en ce que la mémoire comporte un inverseur à seuil (IS1, IS2) pour autoriser la mise en conduction de celui des transistors de charge et de décharge (T1,T2) dont la conduction n'est pas interdite, tant que le potentiel du plot n'a pas atteint la valeur intermédiaire de précharge désirée, et pour arrêter cette conduction dès que le potentiel du plot atteint cette valeur.

2. Mémoire selon la revendication 1, caractérisée en ce que la mémoire est alimentée sous en tension de 5 volts et le niveau intermédiaire est compris entre 1 et 2 volts, de préférence environ 1, 4 volts.

3. Mémoire selon l'un des revendications 1 ou 2, caractérisée en ce que les moyens pour rendre le transistor de charge conducteur comportent une première porte logique (PL1) et les moyens pour rendre le transistor de décharge conducteur comportent une deuxième porte logique (PL2), le circuit de mémorisation étant relié à une entrée de ces portes pendant la phase de précharge.

4. Mémoire selon la revendication 3, caractérisée en ce que l'inverseur à seuil (IS1, IS2) comporte une entrée reliée au plot de sortie et une sortie reliée pendant la phase de précharge aux entrées des portes logiques.

5. Mémoire selon l'une des revendications 3 ou 4, caractérisée en ce que la première porte logique (PL1) est une porte NAND et la deuxième (PL2) est une porte NOR, chacune de ces deux portes ayant deux entrées recevant toutes deux, pendant une phase de lecture suivant la phase de précharge, un signal logique représentant l'information transmise par la ligne de bit.

6. Mémoire selon la revendication 5, caractérisée en ce que la porte NAND et la porte NOR ont chacune une première entrée recevant pendant la précharge la sortie du circuit de mémorisation et une seconde entrée recevant pendant la précharge la sortie de l'inverseur à seuil.

7. Mémoire selon l'une des revendications 3 à 6, caractérisée en ce que le premier inverseur à seuil (IS1) est relié entre le plot et la première porte logique (PL1) pendant la phase de précharge (PRECH) et qu'elle comporte un deuxième inverseur à seuil (IS2) relié entre le plot et la deuxième porte logique (PL2) pendant la phase de précharge.

8. Mémoire selon l'une des revendications 1 à 7, caractérisée en ce qu'elle comporte des circuits de maintien (CM1, CM2, CM3), entre la sortie de l'amplificateur différentiel (AD) et les entrées des portes logiques (PL1, PL2), ces circuits de maintien étant activés entre la fin d'une phase de lecture et le début d'une phase de précharge ultérieure, pour conserver à l'entrée des portes logiques, l'information lue dans la cellule de mémoire.

## Claims

1. Integrated-circuit chip memory having a network of memory cells connected to at least one bit line (BL), the bit line being connected by means of at least one output amplifier (T1, T2) to an output pin of the memory chip (IOPAD), having means (IS1, IS2, PT9, PT10) for precharging the output of the amplifier to a predetermined voltage value during a precharging phase before applying to the pin, through the output amplifier, during a reading phase following the precharging phase, a logic level corresponding to an item of information read in a cell of the memory, the predetermined value being intermediate between a voltage value corresponding to a logic high level and voltage value corresponding to a logic low level, the output amplifier having a charge transistor (T1 ) in series with a discharge transistor (T2), the common point of the transistors being connected to the pin, with means (PL1, PL2) for controlling the conduction of these transistors, these means (PL1, PL2) including means for making the charge transistor (T1) conductive and making the discharge transistor (T2) non-conductive when the information transmitted by the bit line corresponds to a logic high level, and means for making the discharge transistor (T2) conductive and making the charge transistor (T1) non-conductive when the information transmitted by the bit line corresponds to a logic low level, and having, connected to the output pin, a storage circuit (17, 18) able to store in memory, during the precharging phase, the logic level present at the pin during the previous reading phase, this circuit (I7, I8) having its output connected during the precharging phase to the means for controlling the conduction of the charge and discharge transistors, so as to inhibit the conduction of the charge transistor or of the discharge transistor during the precharging depending on whether the logic level stored is high or low, characterised in that the memory has a threshold inverter (IS1, IS2) for enabling the transistor from amongst the charge and discharge transistors (T1, T2) whose conduction has not been inhibited to be made conductive, as long as the potential of the pin has not attained the desired intermediate precharging value, and for stopping this conduction as soon as the potential of the pin reaches this value.

2. Memory according to Claim 1, characterised in that the memory is supplied at a voltage of 5 volts and the intermediate level is between 1 and 2 volts, preferably approximately 1.4 volts.

3. Memory according to one of Claims 1 or 2, characterised in that the means for making the charge transistor conductive include a first logic gate (PL1) and the means for making the discharge transistor conductive include a second logic gate (PL2), the storage circuit being connected to an input of these gates during the precharging phase.

4. Memory according to Claim 3, characterised in that the threshold inverter (IS1, IS2) has an input connected to the output pin and an output connected, during the precharging phase, to the inputs of the logic gates.

5. Memory according to one of Claims 3 or 4, characterised in that the first logic gate (PL1) is a NAND gate and the second (PL2) is a NOR gate, each of these two gates having two inputs both receiving, during a reading phase following the precharging phase, a logic signal representing the information transmitted by the bit line.

6. Memory according to Claim 5, characterised in that the NAND gate and the NOR gate each have a first input receiving, during the precharging, the output of the storage circuit and a second input receiving, during the precharging, the output of the threshold inverter.

7. Memory according to one of Claims 3 to 6, characterised in that the first threshold inverter (IS1) is connected between the pin and the first logic gate (PL1) during the precharging phase (PRECH) and in that it has a second threshold inverter (IS2) connected between the pin and the second logic gate (PL2) during the precharging phase.

8. Memory according to one of Claims 1 to 7, characterised in that it includes maintenance circuits (CM1, CM2, CM3), between the output of the differential amplifier (AD) and the inputs of the logic gates (PL1, PL2), these maintenance circuits being activated between the end of a reading phase and the start of a subsequent precharging phase, in order to store at the input of the logic gates the information read in the memory cell.

## Patentansprüche

1. Integrierter Speicherchip mit einem Netz von Speicherzellen, die über wenigstens eine Bitleitung (L) miteinander verbunden sind, wobei die Bitleitung über wenigstens einen Ausgangverstärker (T1, T2) mit einem Ausgangspin des Speicherchips (IOPAD) verbunden ist, mit Vorrichtungen (IS1, IS2, PT9, PT10) zum Aufladen des Ausgangs des Verstärkers bis auf einen vorgegebenen Spannungswert während einer Aufladungsphase vor dem Anlegen, während einer Lesephase nach der Aufladungsphase, eines logischen Pegels, der einer in einer Speicherzelle gelesenen Information entspricht, an den Pin durch den Ausgangsverstärker, wobei der vorgegebene Wert zwischen einem Spannungswert, der einem hohen logischen Niveau emtspricht, und einem Spannungswert, der einem niedrigen logischen Niveau entspricht, liegt, der Ausgangsverstärker einen Ladetransistor (T1) in Reihe mit einem Entladetransistor (T2) umfaßt, der Verbindungspunkt der Transistoren mit dem Pin verbunden ist, mit Vorrichtungen (PL1, PL2) zum Steuern der Leitfähigkeit der Transistoren, wobei diese Vorrichtungen (PL1, PL2) Vorrichtungen, um den Ladetransistor (T1) leitend zu machen und den Entladetransistor (T2) zu sperren, wenn die auf der Bitleitung übertragene Information einem logisch hohen Niveau entspricht, und Vorrichtungen umfassen, um den Entladetransistor (T2) leitend zu machen und den Ladetransistor (T1) zu sperren, wenn die über die Bitleitung übertragene Information einem logisch niedrigen Niveau entspricht, und mit einem mit dem Ausgangspin verbundenen Abspeicherungsschaltkreis (I7, I8), der dazu dient, während der Aufladungsphase das logische Niveau im Speicher abzulegen, das an dem Pin anliegt während der vorangehenden Lesephase, wobei dieser Schaltkreis (I7, I8) über seinen Ausgang während der Aufladungsphase mit Vorrichtungen verbunden ist, um die Leitfähigkeit von Lade- und Entladetransistor zu steuern, so daß die Leitfähigkeit des Ladetransistors oder des Entladetransistors während der Aufladung herabgesetzt wird, je nachdem ob das abgespeicherte logische Niveau hoch oder niedrig ist,
dadurch gekennzeichnet, daß
der Speicher einen Schwelleninvertierer (IS1, IS2) zum Freigeben der Leitfähigkeit des Lade- und Entladetransistors (T1, T2) umfaßt, deren Leitfähigkeit nicht herabgesetzt wurde, solange das Potential am Pin nicht den gewünschten mittleren Wert beim Aufladen erreicht hat, und um diese Leitfähigkeit festzuhalten, sobald das Potential am Pin diesen Wert erreicht.

2. Speicher nach Anspruch 1, dadurch gekennzeichnet, daß der Speicher versorgt wird mit einer Spannung von 5 V und daß Zwischenniveau zwischen 1 und 2 V, vorzugsweise bei 1,4 V liegt.

3. Speicher nach einem der Ansprüche 1 oder 2, dadurch gekennzeichnet, daß die Vorrichtungen zum Schalten des Ladetransistors in den leitfähigen Zustand ein erstes Logikgatter (PL1) umfassen und die Vorrichtungen zum Schalten des Entladungstransistors in den leitfähigen Zustand ein zweites Logikgatter (PL2) umfassen, wobei der Speicherschaltkreis mit einem Eingang dieser Gatter während der Aufladungsphase verbunden ist.

4. Speicher nach Anspruch 3, dadurch gekennzeichnet, daß der Schwelleninverter (IS1, IS2) über einen Eingang mit dem Ausgangspin und über einen Ausgang während der Aufladungsphase mit den Eingängen von Logikgattern verbunden ist.

5. Speicher nach einem der Ansprüche 3 oder 4, dadurch gekennzeichnet, daß das zweite Logikgatter (PL1) ein NAND-Gatter ist und das zweite (PL2) ein NOR-Gatter ist, wobei jedes dieser zwei Gatter zwei Eingänge aufweist, die beide während einer Lesephase nach der Aufladungsphase ein logisches Signal empfangen, das die über die Bitleitung übertragene Information darstellt.

6. Speicher nach Anspruch 5, dadurch gekennzeichnet, daß das NAND-Gatter und das NOR-Gatter jeweils einen ersten Eingang haben, der während des Aufladens den Ausgang des Speicherschaltkreises empfängt, und einen zweiten Eingang, der während des Aufladens den Ausgang des Schwelleninverters empfängt.

7. Speicher nach einem der Ansprüche 3 bis 6, dadurch gekennzeichnet, daß der erste Schwelleninverter (IS1) zwischen den Pin und das erste Logikgatter (PL1) während der Aufladungsphase (PRECH) geschaltet ist und daß er einen zweiten Schwelleninverter (IS2) umfaßt, der zwischen den Pin und das zweite Logikgatter (PL2) während der Aufladungsphase geschaltet ist.

8. Speicher nach einem der Ansprüche 1 bis 7, dadurch gekennzeichnet, daß er Halteschaltkreise (CM1, CM2, CM3) zwischen dem Ausgang des Differenzverstärkers (AD) und den Eingängen der logischen Gatter (PL1, PL2) umfaßt, wobei diese Halteschaltkreise zwischen dem Ende einer Lesephase und dem Beginn einer späteren Aufladungsphase aktiviert werden, um an dem Eingang von Logikgattern die in der Speicherzelle gelesene Information aufrecht zu erhalten.
